# EUROPÄISCHE PATENTANMELDUNG

(11) **EP 2 151 716 A1**
(43) Veröffentlichungstag der Anmeldung: **10.02.2010**
(21) Anmeldenummer: 09010107.2
(22) Anmeldetag: 05.08.2009
(51) Int. Cl.: G03F 7/20, G03F 7/00

(54) **Element, insbesondere Photopolymer-Einheit**

(30) Priorität: 07.08.2008 AT 12302008
(71) Anmelder: Trodat GmbH, 4600 Wels (AT)
(72) Erfinder: Brunton, Colin, Cottesmore Rutland LE15 7DJ (GB); Veress, Alexander R., Piscataway New Jersey 08854 (US); Roesner, Erik E., Robbinsville New Jersey 08691 (US)
(74) Vertreter: Burger, Hannes

(57) **Zusammenfassung**

Die Erfindung betrifft ein Element (2), insbesondere eine Photopolymer-Einheit, mit einer Rückenschicht (10) und einer Decklage (9), die miteinander zu einem verschlossenen Beutel verbunden sind, in dem eine Vorstufe eines mit elektromagnetischer Strahlung polymerisierbaren Kunststoffes, insbesondere eines Photopolymers (11), eingeschlossen ist. Die Decklage (9) ist aus einem gegossenen Kunststoff hergestellt. Weiters betrifft die Erfindung die Herstellung einer Druckplatte aus diesem Element (2).

## Beschreibung

Die Erfindung betrifft ein Element, insbesondere eine Photopolymer-Einheit, mit einer Rückenschicht und einer Decklage, die miteinander zu einem verschlossenen Beutel verbunden sind, in dem eine Vorstufe eines mit elektromagnetischer Strahlung polymerisierbaren Kunststoffes, insbesondere eines Photopolymers, eingeschlossen ist, ein Verfahren zum Herstellen einer, mit einer reliefartigen ausgebildeten Oberfläche versehenen, Druckplatte für einen Stempel unter Verwendung eines Elementes mit einer Decklage und einer Rückenschicht, die miteinander einen verschlossenen Beutel bilden, in dem eine Vorstufe eines mit elektromagnetischer Strahlung polymerisierbaren Kunststoffes eingeschlossen ist und eine Vorrichtung zur Herstellung einer reliefartigen Druckplatte für einen Stempel, wobei diese eine Fertigungsapparatur mit zwei, insbesondere lichtdurchlässigen, Platten und zumindest einer Strahlungsquelle zur Abgabe von elektromagnetischer Strahlung, insbesondere zumindest eine UV-Lichtquelle, umfasst.

Aus dem Stand der Technik ist bereits bekannt, zur Herstellung von Druckplatten bzw. Textplatten von Stempeln flüssige bzw. pastöse, lichtaushärtende Kunststoffe unter Strahlungseinwirkung selektiv aushärten zu lassen. Das flüssige Photopolymer (Prepolymer) ist dazu in einem aus einer dünnen transparenten Kunststofffolie gebildeten Beutel eingeschlossen. Dazu sind üblicherweise zwei Folien an ihren Rändern miteinander verschweißt, sodass eine Polymereinheit in der Form eines flachen Beutels erhalten wird. Um aus einer solchen Polymereinheit bzw. Polymerpackung eine Druckplatte für einen Stempel herstellen zu können, wird die Photopolymer-Einheit gemeinsam mit einer Maske - üblicherweise in der Form eines fotografischen Negativs - zwischen zwei parallele Glasplatten einer entsprechenden Fertigungs- bzw. Belichtungsapparatur gelegt, wobei die Maske zwischen der unteren transparenten Platte und der Polymereinheit liegt. Somit kommt es durch die von oben erfolgende Strahleneinwirkung und die dadurch bewirkte Aushärtung des Prepolymers zur Ausbildung einer durchgehenden Basisschicht und durch die von unten erfolgende Strahleneinwirkung zu einer entsprechend der Form der Maske gebildeten reliefartigen und mit der Basisschicht verbundenen Struktur. Nach Entnahme der derart strahlenbehandelten bzw. ausgehärteten Photopolymer-Einheit aus der Belichtungsapparatur wird die ausgehärtete Platte aus dem Beutel gelöst und das nicht ausgehärtete Prepolymer von den nicht belichteten Bereichen ausgewaschen. Derartige Verfahren zur Herstellung entsprechender Photopolymer-Einheiten für die Fertigung von Druckplatten von Stempeln sind bereits bekannt aus JP 61041148 A (Maeda et al.) und EP 0 607 106 A1 (De Caria).

Aus der US 2003/0039915 A1 (Holt) sind Photopolymerpackungen zur Herstellung von Druckplatten für Stempel bekannt, wobei die die Beutel der Photopolymerpackungen bildenden Folien aus einem Material hergestellt sind, das von dem ausgehärteten Photopolymer ablösbar ist. Dabei ist insbesondere vorgesehen, dass das Material der Folien Polyolefine umfasst. Weiters ist aus dem Dokument auch bekannt, für die Folien Laminate aus Polyethylen und Polyethylenterephthalat zu verwenden.

Von den Photopolymerpackungen des Standes der Technik ist auch bekannt, dass es bei der Herstellung von Druckplatten mit dem beschriebenen Verfahren sehr häufig zu Beeinträchtigungen der Qualität in Form von Unebenheiten bzw. Deformationen der Konturen der reliefartigen Druckplattenmuster kommt. Eine wesentliche Ursache dafür scheint darin zu liegen, dass die verwendeten Folien beim Einlegen in die Belichtungsapparatur dazu neigen, Falten zu bilden, bzw. aufgrund der Herstellung des Beutels aus den beiden Folien z.B. durch Verschweißen es zur Faltenbildung kommt, insbesondere wenn die beiden Folien aus unterschiedlichen Polymeren mit verschiedenen Wärmedehnungseigenschaften hergestellt ist.

Der vorliegenden Erfindung liegt nun die Aufgabe zugrunde, eine Möglichkeit zur Herstellung einer Druckplatte zu schaffen, mit der eine erhöhte Genauigkeit der Druckmuster erreicht werden kann.

Diese Aufgabe wird jeweils eigenständig durch das eingangs genannte Element, bei dem die Decklage aus einem gegossenen Kunststoff hergestellt ist, durch das Verfahren, das die Verfahrensschritte (1) Legen des Elementes zwischen zwei parallele Platten; (2) Auflegen eines Zwischenstückes auf das Element; (3) Zusammendrücken des Elementes und des Zwischenstückes zwischen den beiden Platten; (4) Bestrahlen der Vorstufe des Elementes mit elektromagnetischer Strahlung, sodass diese unter Bildung der Druckplatte zu einem Polymer polymerisiert, wobei das Zwischenstück die Bildung einer zumindest annähernd glatten Oberfläche des Polymers unterstützt, umfasst, sowie die Vorrichtung, bei der ein Zwischenstück umfasst ist, das zum gemeinsamen Einlegen und Zusammendrücken zwischen den Platten gemeinsam mit einem Element, insbesondere einer Photopolymer-Einheit, vorgesehen ist, wobei das Element durch einen Beutel mit einer darin eingeschlossenen flüssigen bzw. gelartigen, polymerisierbaren Vorstufe eines Kunststoffes, insbesondere eines Photopolymers, gebildet ist, gelöst.

Überraschenderweise hat sich herausgestellt, dass eine Verbesserung der Lichttransparenz und somit eine deutlich verbesserte Auflösung der Schrift auf der Druckplatte erreicht werden kann, wenn die Decklage nicht aus einer extrudierten Kunststofffolie hergestellt wird, sondern aus einer gegossenen Kunststofffolie. Gegossene Kunststofffolien können aber, insbesondere bei geringer Schichtdicke, zur Faltenbildung neigen. Eine Reduktion der Faltenbildung ist durch die Verwendung eines Zwischenstückes möglich, indem durch das Auflegen des Zwischenstückes auf die Decklage diese zumindest annähernd parallel zu den Platten, zwischen denen das Element angeordnet wird, über zumindest einen Großteil der Fläche durch das Zusammendrücken der Platten gespannt wird. Durch die Reduktion der Faltenbildung wird eine gleichmäßigere Belichtung ermöglicht, indem der Anteil an Streulicht reduziert werden kann, bzw. die zu durchstrahlende Dicke der Folie über die gesamte Fläche zumindest annähernd gleich ist, wodurch das mithilfe eines Negativs auf der herzustellenden Druckplatte erzeugte reliefartige Druckmuster eine höhere Genauigkeit aufweist und zudem die Oberfläche im Bereich des Druckmusters glatter erzeugt werden kann, was wiederum positive Eigenschaften auf das von der Druckplatte erzeugbare Druckbild hat.

Die Rückenschicht der Einheit kann zumindest einen Polyester umfassen, da damit erreicht werden kann, dass die Rückenschicht auf der Druckplatte auch nach deren Herstellung haften bleibt. Es ist damit eine bessere Handhabbarkeit der Druckplatte erzielbar.

Zur Verbesserung dieses Effektes des Haftens ist in einer Ausführungsvariante vorgesehen, dass die Rückenschicht eine Beschichtung aus einem Polymer-Werkstoff aufweist, die in direktem Kontakt mit der Vorstufe angeordnet ist, wobei die Beschichtung das Anhaften der Rückenschicht an dem aus der Vorstufe gebildeten Kunststoff unterstützt.

Als besonders geeignet hat sich als Polymer-Werkstoff der Beschichtung ein PVC-PVAc-Copolymer (Polyvinylchlorid-Polyvinylacetat-Copolymer) erwiesen.

Bevorzugt umfasst der gegossene Kunststoff der Decklage (9) ein gegossenes PVC. Es wird damit eine sehr hohe Transparenz der Decklage erreicht, womit eine weitere Erhöhung der Genauigkeit der Druckplatte im Bereich der reliefartigen Struktur erreichbar ist.

Eine Verbesserung der Druckbildqualität durch eine gleichmäßigere Bestrahlung kann erreicht werden, wenn die Rückenschicht eine Dicke aufweist, die ausgewählt ist aus einem Bereich mit einer unteren Grenze von 25 µm und einer oberen Grenze von 150 µm und/oder wenn die Decklage eine Dicke aufweist, die ausgewählt ist aus einem Bereich mit einer unteren Grenze von 15 µm und einer oberen Grenze von 125 µm.

Zur weiteren Verbesserung der damit erreichten Effekte kann die Rückenschicht insbesondere auch eine Dicke aufweisen, die ausgewählt ist aus einem Bereich mit einer unteren Grenze von 50 µm und einer oberen Grenze von 100 µm, bzw. einem Bereich mit einer unteren Grenze von 50 µm und einer oberen Grenze von 80 µm, und die Decklage eine Dicke aufweisen, die ausgewählt ist aus einem Bereich mit einer unteren Grenze von 25 µm und einer oberen Grenze von 60 µm, bzw. einem Bereich mit einer unteren Grenze von 25 µm und einer oberen Grenze von weniger als 50 µm.

Gemäß einer Ausführungsvariante des Verfahrens ist vorgesehen, dass der Schritt des Auflegens des Zwischenstücks auf das Element das Anordnen eines geschlossenen Rahmens mit einem offenen Zentralbereich oberhalb des Elementes umfasst, wodurch die auf das Element, insbesondere die Rückenschicht, aufgebrachte Spannung vergleichmässigt werden kann. Zudem kann damit erreicht werden, dass über diesen Zentralbereich überschüssiges Polymer, d.h. die flüssige bzw. gelartige bzw. pastöse Vorstufe bei Druckeinwirkung über die Platten ausweichen kann. Für letzteren Zweck besteht aber auch die Möglichkeit, gegebenenfalls zusätzlich, dass der Rahmen entsprechende Aussparungen bzw. Öffnungen aufweist, beispielsweise sich durch den Rahmen hindurch erstreckende, horizontal verlaufende Durchbrüche.

Bevorzugt wird, wenn eine Maske in der Form eines Negativs, insbesondere eines Negativfilms, zwischen dem Element und einer der beiden Platten angeordnet wird, da damit gleichzeitig durch das Zusammenpressen der Platten diese Maske zumindest annähernd parallel zum Element und/oder zumindest annähernd ebenflächig ausgerichtet wird.

Die parallelen Platten werden aus Transparenzgründen insbesondere aus Glas hergestellt und es wird zumindest je eine elektromagnetische Strahlungsquelle oberhalb und unterhalb der Platten so angeordnet, dass die Strahlung zumindest durch einen Teil einer Glasplatte und zumindest durch einen Teil der Maske hindurch übertragen wird, bevor die Vorstufe des Kunststoffes belichtet wird. Es kann damit eine Vergleichmäßigung der eingebrachten Strahlung über die Platten erreicht werden.

Wie bereits voranstehend ausgeführt, wird das Zwischenstück, insbesondere die rahmenförmige Maske bevorzugt in einer sich parallel zur Oberfläche des Elementes erstreckenden Ebene angeordnet.

Zum besseren Verständnis der Erfindung wird diese anhand der nachfolgenden Figuren näher erläutert.

Es zeigen jeweils in stark schematisch vereinfachter Darstellung:
- Fig. 1: einen Ausschnitt einer Vorrichtung zur Strahlenbehandlung eines erfindungsge- mäßen Elementes;
- Fig. 2: ein Element mit einer Maske und einem rahmenförmigen Zwischenstück in per- spektivischer Ansicht;
- Fig. 3: einen Querschnitt des zwischen den Platten der Vorrichtung gemeinsam mit dem Zwischenstück eingespannten Elementes;
- Fig. 4: einen Querschnitt eines Elementes gemäß einem weiteren Ausführungsbeispiel.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1 oder 5,5 bis 10.

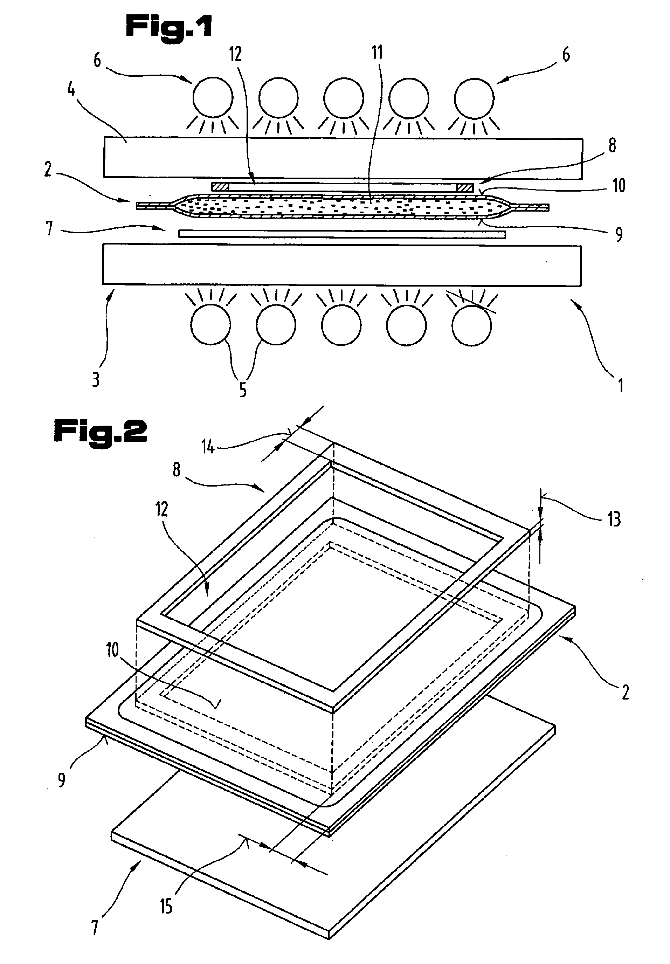

Die Fig. 1 zeigt einen Ausschnitt einer Fertigungsapparatur 1 zur Strahlenbehandlung eines Elementes 2, insbesondere einer Photopolymer-Einheit.

Die Fertigungsapparatur 1 umfasst zunächst eine untere und eine obere lichtdurchlässige Platte 3, 4, die bspw. aus Glas oder transparenten Kunststoffplatten hergestellt sein können. Unterhalb der unteren Platte 3 als auch oberhalb der oberen Platte 4 sind jeweils Strahlungsquellen zur Abgabe von elektromagnetischer Strahlung, insbesondere Lichtquellen 5, 6, die vorzugsweise durch UV-Lampen gebildet sind, angeordnet. Auf der unteren Platte 3 liegt die Maske 7, die vorzugsweise durch ein Fotonegativ gebildet ist, jedoch auch durch eine andere geeignete Negativform gebildet sein kann, mit der die Herstellung einer reliefartig strukturierten Oberfläche eines Druckelementes, insbesondere einer Druckplatte, ermöglicht wird. Auf der Maske 7 liegt sodann das Element 2. Zwischen dem Element 2 und der oberen Platte 4 ist schließlich noch ein Zwischenstück 8 angeordnet.

Die Negativform kann dem Stand der Technik entsprechend ausgeführt sein.

Die Photopolymer-Einheit 2 hat die Form eines flachen Beutels und besteht aus einer Decklage 9 und einer Rückenschicht 10, die aus transparenten Kunststofffolien gebildet sind. Zwischen der Decklage 9 und der Rückenschicht 10, die an ihren äußeren Rändern miteinander verschweißt oder verklebt sind, ist eine flüssige bzw. gelartige bzw. pastöse Vorstufe eines Kunststoffes, der durch Einwirkung elektromagnetischer Strahlung polymerisiert werden kann, gegebenenfalls unter Zuhilfenahme von Polymerisationshilfsmittel, wie z.B. Radikalbildnern eingeschlossen. Die Vorstufe kann durch Monomereinheiten oder bereits teilweise vorpolymerisierte Oligomer- bzw. Prepolymereinheiten gebildet sein. Vorzugsweise handelt es sich dabei um ein so genanntes Photopolymer 11, das mit Hilfe von Licht, also beispielsweise UV- und/oder sichtbares Licht, polymerisiert, d.h. gehärtet werden kann. Es können allerdings auch andere Vorstufen verwendet werden, die mittels anderer elektromagnetischer Strahlung, z.B. Laserstrahlung, Elektronenstrahlung, Wärmestrahlung, etc. polymerisiert werden können, wobei auch Mischformen möglich sind. Da diese Vorstufen bereits aus dem Stand der Technik und auch die Polymerisation mittels elektromagnetischer Strahlung bereits aus dem Stand der Technik bekannt sind, sei hierzu auf die einschlägige Literatur, insbesondere im Zusammenhang mit der Herstellung von Druckplatten, beispielsweise auf die voranstehend zitierten Dokumente zum Stand der Technik, verwiesen.

Die Rückenschicht 10 ist vorzugsweise dazu ausgebildet, an den ausgehärteten festen (Photo)Polymer haften zu bleiben und die Decklage 9 ist vorzugsweise dazu ausgebildet ist, von dem ausgehärteten (Photo)Polymer ablösbar zu sein.

Aus Gründen der Übersichtlichkeit sind in der Fig. 1 die Platten 3, 4, die Maske 7, das Element 2, also die Photopolymer-Einheit, und das Zwischenstück 8 von einander distanziert in Explosionsdarstellung dargestellt. Vor Beginn des Belichtungsvorgangs des Elementes 2 werden die beiden Platten 3, 4 aufeinander zu bewegt, sodass die Maske 7, das Element 2 und das Zwischenstück 8 gegeneinander gedrückt und so das Element 2 unter mechanischer Spannung zwischen den Platten 3, 4 festgehalten wird. Gemäß dem dargestellten Ausführungsbeispiel hat das Zwischenstück 8 die Form eines rechteckigen Rahmens mit einem offenen Zentralbereich 12, wie anhand der Fig. 2 dargestellt ist.

In Fig. 2 sind die Maske 7, das Element 2 und das durch einen Rahmen gebildete Zwischenstück 8 in vertikaler Richtung versetzt dargestellt. Die äußeren Abmessungen des Zwischenstücks 8 sind im Verhältnis zu den äußeren Abmessungen des ebenfalls rechteckigen Elementes 2 so bemessen, dass der Rahmen des Zwischenstücks 8 innerhalb des äußeren Randes des Elementes 2 an diesem zur Anlage kommt. Diese horizontale, relative Ausrichtung ist strichliert angedeutet.

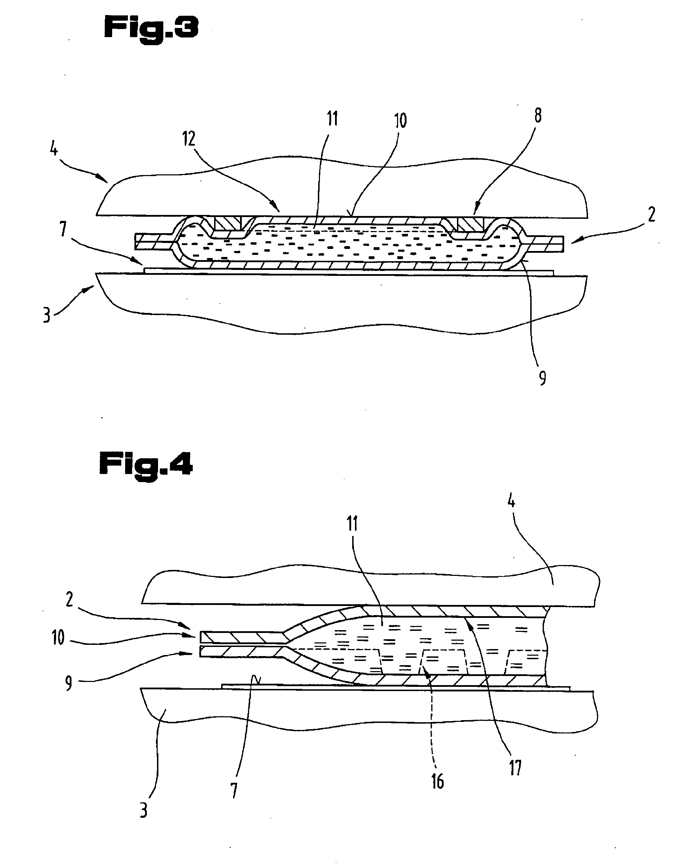

Die Fig. 3 zeigt einen Querschnitt des zwischen den Platten 3, 4 der Fertigungsapparatur 1 (Fig. 1) eingespannten Elementes 2. Der in Reaktion auf das Zusammendrücken der Platten 3, 4 der Fertigungsapparatur 1 in dem flüssigen (Photo)Polymer 11 erhöhte hydrostatische Druck, führt zu einer entsprechenden Deformation der Rückenschicht 10, wobei diese in den Zentralbereich 12 des Zwischenstücks 8 als auch im Bereich außerhalb des äußeren Randes des Zwischenstücks 8 gegen die obere Platte 4 gedrückt wird. Es hat sich überraschenderweise gezeigt, dass durch die derart hervorgerufene Deformation der Rückenschicht 10 des Elementes 2 eine Faltenbildung in der Rückenschicht 10 als auch in der Decklage 9, d.h. in dem Zentralbereich 12, zumindest annähernd gänzlich verhindert wird. Nach durch Bestrahlung, insbesondere mit UV Licht, erfolgter Aushärtung und Bildung einer festen Druckplatte, wird somit mit Hilfe des Zwischenstücks 8 die Bildung von glatten Oberflächen an der fertigen Druckplatte erreicht.

Das rahmenförmige Zwischenstück 8 hat beispielsweise ein Flächenausmaß entsprechend einem DIN A4 Blatt mit einer Dicke 13 (Fig. 2) aus einem Bereich von 1 mm bis 2,5 mm. Der Querschnitt des rahmenförmigen Zwischenstücks 8 weist weiters eine Rahmenbreite 14 (Fig. 2) aus einem Bereich von 4 mm bis 10 mm auf. Für das Ausmaß des Flächenverhältnisses des Elementes 2 und des rahmenförmigen Zwischenstücks 8 ist ein Randabstand 15 aus einem Bereich von 15 mm bis 25 mm vorgesehen. Das Zwischenstück 8 ist vorzugsweise aus Plexiglas hergestellt, alternativ können aber auch andere Kunststoffe oder Metalle für die Herstellung verwendet werden. Neben dem rahmenförmigen Zwischenstück 8, wie in den Fig. 1 bis 3 beschrieben, können auch andere Formen als Zwischenstück 8 verwendet werden. So zum Beispiel kann das Zwischenstück 8 in der Form eines Gitters mit mehreren, offenen Bereichen ausgebildet sein, also der Zentralbereich 12 auf mehrere Teilbereiche aufgeteilt sein. Dies kann beispielsweise dann von Vorteil sein, wenn, wie zumeist üblich, mehrere Stempelplatten gleichzeitig aus einem entsprechend großen Element 2 hergestellt werden. Die Anordnung der Druckmuster auf dem Photonegativ (Maske 7) ist dabei auf das Raster des Zwischenstücks 8 abzustimmen.

Mit dem gemäß den Fig. 1 bis 3 beschriebenen System einer Belichtungseinrichtung zum Aushärten von (Photo)Polymeren beziehungsweise einer Fertigungsapparatur 1, kann somit das erfindungsgemäße Verfahren zur Herstellung einer Druckplatte für einen Stempel ausgeführt werden. Dieses Verfahren erfolgt, wie vorstehend beschrieben, unter Verwendung einer (Photo)Polymerpackung beziehungsweise Photopolymer-Einheit, d.h. dem Element 2, mit einem aus einer Rückenschicht 10 und einer Decklage 9 gebildeten, versiegelten Kissen, in dem ein flüssiges, gelartiges oder pastöses (Photo)Polymer eingeschlossen ist. Gemäß diesem Verfahren wird das Element 2 zwischen die zwei parallelen Platten 3, 4 der Fertigungsapparatur 1 eingelegt, wobei auf dem Element 2 ein Zwischenstück 8 platziert wird. Das Element 2 wird gemeinsam mit dem darauf liegenden Zwischenstück 8 zwischen den Platten 3, 4 der Fertigungsapparatur 1 zusammengedrückt und das flüssige (Photo)Polymer 11 beziehungsweise das Prepolymer mit elektromagnetischer Strahlung, insbesondere UV Licht, bestrahlt bzw. belichtet, sodass dieses polymerisiert und eine feste Druckplatte geformt wird. Das Zwischenstück 8 begünstigt dabei die Bildung einer glatten Oberfläche der festen Druckplatte. Bevorzugt wird bei dem Verfahren ein Zwischenstück 8 in der Form eines Rahmens mit einem offenen Zentralbereich 12 verwendet. Das rahmenförmige Zwischenstück 8 wird vorzugsweise an die Rückenschicht 10 des Elementes 2 angelegt, kann alternativ aber auch an die Deckenlage 9 angelegt werden. Die Lichtquelle(n) 5, 6 bzw. die Strahlungsquelle(n) wird/werden so angeordnet, dass das UV Licht bzw. die elektromagnetische Strahlung, bevor es das flüssige (Photo)Polymer 11 belichtetet, durch zumindest eine der Platten 3, 4 und zumindest einen Teil des Negativfilms beziehungsweise einen Teil der Maske 7 hindurch tritt.

Anhand der Fig. 4 wird ein weiteres Ausführungsbeispiel eines Elementes 2 zur Herstellung einer Druckplatte eines Stempels beschrieben.

Das Element 2 ist gemäß der Darstellung gemeinsam mit der Maske 7 zwischen der unteren Platte 3 und der oberen Platte 4 der Fertigungsapparatur 1 (Fig. 1) eingelegt gezeigt und wird zwischen diesen Platten 3, 4 zusammengedrückt. Dabei ist die Maske 7 auf der unteren Platte 3 liegend angeordnet, sodass das Element 2 mit der Decklage 9 an der Maske 7 anliegt und die Rückenschicht 10 des Elementes 2 an der oberen Platte 4 anliegt.

Die Decklage 9 des Elementes 2 gemäß diesem Ausführungsbeispiel wird durch eine gegossene Kunststofffolie gebildet. Es hat sich gezeigt, dass gegossene Kunststofffolien den Strahlungsdurchtritt bei dem Belichtungsvorgang nur minimal stören und so eine hohe Fertigungsgenauigkeit bei der Herstellung der Druckplatten 16 erreicht werden kann. Für die Decklage 9 werden bevorzugt gegossene Kunststofffolien aus den folgenden Kunststoffpolymeren verwendet: Cellulosenitrat, Celluloseacetat, Cellulosetriacetat, Polycarbonat, Polyethersulfon, Polyetherimid, Polyvinyliden-Fluorid, Polyimid, Polyvinylalkohol, Methylcellulose, Stärkederivat oder Gelatine. Als besonders geeignet für die Decklage 9 haben sich gegossene Folien aus Polyvinylchlorid (PVC) erwiesen. Die Dicke dieser gegossenen Kunststofffolien hat bevorzugt einen Wert in einem Bereich zwischen 15 Mikrometer und 125 Mikrometer, insbesondere 25 Mikrometer bis 60 Mikrometer.

Die Herstellung von gegossenen Kunststofffolien erfolgt durch Ausgießen von Kunststofflösungen aus einer Breitschlitzdüse auf eine umlaufende Trommel oder ein endloses Metallband. Dazu werden zunächst Polymer-Werkstoffe mit Hilfe eines Lösungsmittels zu einer Kunststofflösung aufbereitet, die anschließend sehr dünn auf eine Oberfläche aufgetragen werden kann. Nach Verdampfung des Lösungsmittels erfolgt sodann eine Verfestigung zu einer dünnen Folie bzw. einem dünnen Film. Dieses Verfahren ist als so genanntes Solvent Cast Verfahren bekannt.

Gemäß einer Ausführungsvariante des Elementes 2 ist vorgesehen, dass die Rückenschicht 10 nach dem Belichtungs- beziehungsweise Aushärtevorgang des (Photo)Polymers 11 von der dabei gebildeten Druckplatte 16 ablösbar ist. Das Element 2 weist dabei eine aus einer Polyethylenfolie gebildete Rückenschicht 10 und eine aus einer gegossenen Kunststofffolie, insbesondere einer gegossenen PVC-Folie, gebildete Decklage 9 auf.

Bei dem Element 2 gemäß einem weiteren Ausführungsbeispiel ist vorgesehen, dass die Rückenschicht 10 nach der Belichtung und Aushärtung des (Photo)Polymers 11 an der dabei gebildeten Druckplatte 16 (strichliert angedeutet) haften bleibt. Dazu kann die Rückenschicht 10 eine Beschichtung 17 aufweisen, die an ihrer dem (Photo)Polymer 11 zugewandten Seite vorgesehen ist. Für die Rückenschicht 10 wird vorzugsweise eine speziell beschichtete Polyesterfolie verwendet. Als Beschichtung 17 wird dazu ein Material gewählt, das eine gute Haftung an dem ausgehärteten (Photo)Polymer 11 beziehungsweise der Druckplatte 16 bewirkt. Das Material der Beschichtung 17 ist gleichzeitig auch geeignet, eine ausreichend gute Verschweißung mit der Decklage 9 sicher zu stellen und in dem flüssigen (Photo)Polymer 11 nicht in Lösung zu gehen. Als Beschichtung 17 ist vorzugsweise ein PVC-Polyvinylacetat-Copolymer vorgesehen, dass sich dafür als besonders geeignet erwiesen hat.

Die als Rückenschicht 10 verwendeten Kunststofffolien haben vorzugsweise eine Dicke in einem Bereich zwischen 25 Mikrometer und 150 Mikrometer, insbesondere zwischen 50 Mikrometer und 100 Mikrometer.

Geeignete Folien für die Rückenschicht 10 sind z.B. unter der Bezeichnung Skyrol^{®} erhältlich. Geeignete Folien für die Decklage 9 sind z.B. unter der Bezeichnung LXP-453 bei VCF Films Inc. erhältlich. Geeignete Beschichtungen der Rückenschicht 10 sind z.B. unter der Bezeichnung UCAR^{®}VAGC von DOW Chemical Company beziehbar.

Mit dem erfindungsgemäßen Verfahren können Druckplatten 16 beispielsweise für das Flexodruckverfahren, für Handstempel, für so genannte Art Stamps, etc. hergestellt werden.

Die Ausführungsbeispiele zeigen mögliche Ausführungsvarianten des Elementes 2 bzw. des Verfahrens zur Herstellung einer Druckplatte 16, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Ordnung halber sei abschließend darauf hingewiesen, dass zum besseren Verständnis des Aufbaus des Elementes 2 dieses bzw. dessen Bestandteile teilweise unmaßstäblich und/oder vergrößert und/oder verkleinert dargestellt wurden.

### Bezugszeichenaufstellung

- 1: Fertigungsapparatur
- 2: Element
- 3: Platte
- 4: Platte
- 5: Lichtquelle

- 6: Lichtquelle
- 7: Maske
- 8: Zwischenstück
- 9: Decklage
- 10: Rückenschicht

- 11: Photopolymer
- 12: Zentralbereich
- 13: Dicke
- 14: Breite
- 15: Randabstand

- 16: Druckplatte
- 17: Beschichtung

## Patentansprüche

1. Element (2), insbesondere Photopolymer-Einheit, mit einer Rückenschicht (10) und einer Decklage (9), die miteinander zu einem verschlossenen Beutel verbunden sind, in dem eine Vorstufe eines mit elektromagnetischer Strahlung polymerisierbaren Kunststoffes, insbesondere eines Photopolymers (11), eingeschlossen ist, **dadurch gekennzeichnet, dass** die Decklage (9) aus einem gegossenen Kunststoff hergestellt ist.

2. Element (2) nach Anspruch 1, **dadurch gekennzeichnet, dass** die Rückenschicht (10) zumindest einen Polyester umfasst.

3. Element (2) nach Anspruch 1 oder 2, **dadurch gekennzeichnet, dass** die Rückenschicht (10) eine Beschichtung (17) aus einem Polymer-Werkstoff aufweist, die in direktem Kontakt mit der Vorstufe angeordnet ist, wobei die Beschichtung (17) das Anhaften der Rückenschicht (10) an dem aus der Vorstufe gebildeten Kunststoff unterstützt.

4. Element (2) nach Anspruch 3, **dadurch gekennzeichnet, dass** der Polymer-Werkstoff der Beschichtung (17) ein PVC-PVAc-Copolymer umfasst.

5. Element (2) nach einem der Ansprüche 1 bis 4, **dadurch gekennzeichnet, dass** der gegossene Kunststoff der Decklage (9) ein gegossenes PVC umfasst.

6. Element (2) nach einem der Ansprüche 1 bis 5, **dadurch gekennzeichnet, dass** die Rückenschicht (10) eine Dicke aufweist, die ausgewählt ist aus einem Bereich mit einer unteren Grenze von 25 µm und einer oberen Grenze von 150 µm.

7. Element (2) nach Anspruch 6, **dadurch gekennzeichnet, dass** die Rückenschicht (10) eine Dicke aufweist, die ausgewählt ist aus einem Bereich mit einer unteren Grenze von 50 µm und einer oberen Grenze von 100 µm.

8. Element (2) nach einem der Ansprüche 1 bis 7, **dadurch gekennzeichnet, dass** die Decklage (9) eine Dicke aufweist, die ausgewählt ist aus einem Bereich mit einer unteren Grenze von 15 µm und einer oberen Grenze von 125 µm.

9. Element (2) nach Anspruch 8, **dadurch gekennzeichnet, dass** die Decklage (9) eine Dicke aufweist, die ausgewählt ist aus einem Bereich mit einer unteren Grenze von 25 µm und einer oberen Grenze von 60 µm.

10. Verfahren zum Herstellen einer reliefartigen Druckplatte (16) für einen Stempel unter Verwendung eines Elementes (2), insbesondere einer Photopolymer-Einheit (2), mit einer Decklage (9) und einer Rückenschicht (10), die miteinander einen verschlossenen Beutel bilden, in dem eine Vorstufe eines mit elektromagnetischer Strahlung polymerisierbaren Kunststoffes, insbesondere eines Photopolymers (11), eingeschlossen ist, insbesondere unter Verwendung eines Elementes (2) nach einem der Ansprüche 1 bis 9, **gekennzeichnet durch** folgende Verfahrensschritte:
- Legen des Elementes (2) zwischen zwei parallele Platten (3, 4);
- Auflegen eines Zwischenstückes (8) auf das Element (2);
- Zusammendrücken des Elementes (2) und des Zwischenstückes (8) zwischen den beiden Platten (3, 4);
- Bestrahlen der Vorstufe des Elementes (2) mit elektromagnetischer Strahlung, sodass diese unter Bildung der Druckplatte (16) zu einem Polymer polymerisiert, wobei das Zwischenstück (8) die Bildung einer zumindest annähernd glatten Oberfläche des Polymers unterstützt.

11. Verfahren nach Anspruch 10, **dadurch gekennzeichnet, dass** der Schritt des Auflegens des Zwischenstücks (8) auf das Element (2) das Anordnen eines geschlossenen Rahmens mit einem offenen Zentralbereich (12) oberhalb des Elementes (2) umfasst.

12. Verfahren nach Anspruch 11, **dadurch gekennzeichnet, dass** der Rahmen oberhalb der Rückenschicht (10) des Elementes (2) angeordnet wird.

13. Verfahren nach einem der Ansprüche 10 bis 13, **dadurch gekennzeichnet, dass** eine Maske (7) in der Form eines Negativs, insbesondere eines Negativfilms, zwischen dem Element (2) und einer der beiden Platten (3, 4) angeordnet wird.

14. Verfahren nach Anspruch 13, **dadurch gekennzeichnet, dass** parallele Platten (3, 4) aus Glas hergestellt werden und zumindest je eine elektromagnetische Strahlungsquelle oberhalb und unterhalb der Platten (3, 4) so angeordnet ist, dass die Strahlung zumindest durch einen Teil einer Glasplatte (3, 4) und zumindest durch einen Teil der Maske (7) hindurch übertragen wird, bevor die Vorstufe des Kunststoffes belichtet wird.

15. Verfahren nach einem der Ansprüche 10 bis 14, **dadurch gekennzeichnet, dass** das Zwischenstück (8), insbesondere die rahmenförmige Maske (7) in einer sich parallel zur Oberfläche des Elementes (2) erstreckenden Ebene angeordnet ist.

16. Vorrichtung zur Herstellung einer reliefartigen Druckplatte (16) für einen Stempel, wobei diese eine Fertigungsapparatur (1) mit zwei, insbesondere lichtdurchlässige, Platten (3, 4) und zumindest eine Strahlungsquelle zur Abgabe von elektromagnetischer Strahlung, insbesondere zumindest eine UV-Lichtquelle (5, 6), umfasst, **dadurch gekennzeichnet, dass** ein Zwischenstück (8) umfasst ist, das zum gemeinsamen Einlegen und Zusammendrücken zwischen den Platten (3, 4) gemeinsam mit einem Element (2), insbesondere einer Photopolymer-Einheit, insbesondere nach einem der Ansprüche 1 bis 9, vorgesehen ist, wobei das Element (2) durch einen Beutel mit einer darin eingeschlossenen flüssigen bzw. gelartigen, polymerisierbaren Vorstufe eines Kunststoffes, insbesondere eines Photopolymers, gebildet ist.

17. Vorrichtung nach Anspruch 16, **dadurch gekennzeichnet, dass** das Zwischenstück (8) einen geschlossenen Rahmen umfasst, der in einer sich parallel bezüglich der Oberfläche des Elementes (2) erstreckenden Ebene angeordnet ist, wobei das rahmenförmige Zwischenstück (8) einen offenen Zentralbereich umfasst.

18. Vorrichtung nach Anspruch 17, **dadurch gekennzeichnet, dass** das Kissen des Elementes (2) eine aus einem Polymer-Werkstoff hergestellte Decklage (9) und eine aus einem Polymer-Werkstoff hergestellte Rückenschicht (10) umfasst, und das rahmenförmige Zwischenstück (8) oberhalb der Rückenschicht (10) angeordnet ist.

19. Vorrichtung nach Anspruch 17, **dadurch gekennzeichnet, dass** eine durch eine Negativform, insbesondere einen Negativfilm, gebildete Maske (7) zwischen dem Element (2) und einer der beiden Platten (3, 4) angeordnet ist.

20. Vorrichtung nach Anspruch 19, **dadurch gekennzeichnet, dass** die lichtdurchlässigen Platten (3, 4) aus Glas hergestellt sind und die elektromagnetischen Strahlungsquellen, insbesondere die UV-Lichtquellen (5, 6), so angeordnet sind, dass die elektromagnetische Strahlung zumindest durch eine der beiden Platten (3, 4) und zumindest durch einen Teil der Maske (7) hindurch tritt, bevor die Vorstufe des Kunststoffes bestrahlt wird.
